(19) Europäisches Patentamt
European Patent Office
Office européen des brevets

(11) Publication number: **0 406 669 A2**

(12) # EUROPEAN PATENT APPLICATION

(21) Application number: **90112125.1**

(22) Date of filing: **26.06.90**

(51) Int. Cl.5: **C23C 14/34**, C23C 14/50, H01L 21/203, G01K 17/06

The title of the invention has been amended (Guidelines for Examination in the EPO, A-III, 7.3).

(30) Priority: **26.06.89 JP 160736/89**

(43) Date of publication of application: **09.01.91 Bulletin 91/02**

(84) Designated Contracting States: **DE FR GB**

(71) Applicant: **HITACHI, LTD.**
**6, Kanda Surugadai 4-chome**
**Chiyoda-ku, Tokyo 101(JP)**

(72) Inventor: **Shimizu, Tamotsu**
**3242-17 Nakata-cho, Izumi-ku**
**Yokohama-shi, Kanagawa-ken 245(JP)**
Inventor: **Tamura, Hitoshi**
**Keimei-ryo, 850 Maioka-cho, Totsuka-ku**
**Yokohama-shi, Kanagawa-ken 244(JP)**
Inventor: **Terakado, Masatomo**
**Keimei-ryo, 850 Maioka-cho, Totsuka-ku**
**Yokohama-shi, Kanagawa-ken 244(JP)**
Inventor: **Sasaki, Shinji**
**Keimei-ryo, 850 Maioka-cho, Totsuka-ku**
**Yokohama-shi, Kanagawa-ken 244(JP)**
Inventor: **Tateishi, Hideki**
**3-7-1-706 Namiki, Kanazawa-ku**
**Yokohama-shi, Kanagawa-ken 236(JP)**
Inventor: **Saito, Hiroshi**
**6395-80 Tsujido**
**Fujisawa-shi, Kanagawa-ken 251(JP)**

(74) Representative: **Patentanwälte Beetz sen. - Beetz jun. Timpe - Siegfried - Schmitt-Fumian- Mayr**
**Steinsdorfstrasse 10**
**D-8000 München 22(DE)**

(54) **Thin film making method on semiconductor substrate and temperature controlling systems therefor.**

(57) When a thin film is formed on a semiconductor substrate (9) by making the film forming particles and the charged particles incident on the substrate (9) as in bias-sputtering, the temperature of the semiconductor substrate (9) during thin film formation can be maintained at a desired temperature by measuring the incident heat amount on the semiconductor substrate (9) as well as introducing a rare gas (14) between the semiconductor substrate (9) and a substrate supporting member (10) on which the semiconductor substrate (9) is mounted and then controlling the pressure of the introduced gas (14) in correspondence with the heat amount measured. The thin film formed in this way has high quality and low speoific resistance as well.

FIG. 1

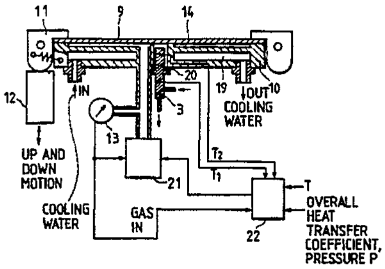


EP 0 406 669 A2

# THIN FILM MAKING METHOD ON SEMICONDUCTOR SUBSTRATE AND SYSTEMS THEREFOR

## BACKGROUND OF THE INVENTION

This invention relates to a thin film making method on semiconductor substrate and systems therefor which have been designed to enable high-quality thin film to be formed or worked by controlling the temperature of a treated substrate and by making film forming particles and charged particles incident on the treated substrate.

A conventional system, for example, a thin film forming system will be hereunder described by way of a sputtering system.

The conventional thin film forming system is discussed in pages 41 to 48 of the Solid State Technology, Japanese edition, March (1981). With a treated substrate placed adjacent to a copper block cooled or heated, a fluid (argon gas in this example) is introduced between the copper block and the substrate. Gas pressure between the block and a substrate ranges from 100 to 300 Pa. For heating the substrate, the copper block is heated with a heater fitted to the copper block, so that the substrate is set at a predetermined temperature.

The overall heat transfer coefficient between the substrate and the copper block is determined in line with determination of the kind of gas, its pressure, and the gap between the substrate and copper block. In this case, since heat source is only a heater, if the relationship between the temperature of the copper block and that of the substrate has been calibrated in advance, the temperature of substrate can be learned by merely measuring the copper block temperature without direct measurement of the substrate temperature.

However, the thin film forming system set forth in the above-mentioned literature has been having a problem that when charged particles are made incident from plasma on a substrate for film formation as in film forming by bias-sputtering, substrate temperature during formation of thin film cannot be controlled due to energy by charged particles or the like, which are made incident on a substrate from sources other than the copper block.

The temperature of the substrate can be measured if a thermocouple is fixed to the substrate so as to be made into direct contact with it with silver paste (which is used when a sample is fitted to the sample holder of an electron microscope), but this cannot be put into practical use because substrate transfer is disturbed. In the method of making a thermocouple in contact with substrate with addition of pressure thereto, moreover, a considerable pressure (20 $kgf/cm^2$) will be required to improve thermal conductivity between the thermocouple and the substrate and to have the thermocouple indicate the substrate temperature, and thin film substrate such as a silicon wafer will be caused broken. In non-contact temperature measuring by a radiation thermometer, in addition, since the thermal radiation rate of the substrate will change in the course of thin film forming, the substrate temperature during film formation cannot be measured.

With the conventional type of thin film forming systems, as described above, the substrate temperature in the course of thin film forming cannot be controlled. Consequently, when, for example, an Al-4 wt% Cu alloy is used as a connection material of VLSI, an $Al_2Cu$ phase will be formed, resulting in an increase in the electric resistance of the connection film. The rise of the electric resistance of the connection film will cause functional defect due to delayed signals and heating, which is far from desirable. When a substrate is maintained at low temperature to prevent such an undesirable phase forming as $Al_2Cu$ in connection film, low-density and coarse film will be formed, likewise leading to an increase in the resistance of the wiring.

## SUMMARY OF THE INVENTION

The object of the present invention is to provide a thin film making method on a semiconductor substrate and systems therefor, which measure an incident heat amount on the treated substrate such as a semiconductor substrate on which thin film is worked by making charged particles and/or film forming particles incident on the substrate, which control the thermal conductivity for transferring the heat to the substrate in correspondence with said heat amount measured, and which maintain the treated substrate such as a semiconductor substrate at desired temperature, thus enabling the working of high-quality thin film.

Another object of the present invention is to provide systems for working thin film, which enables the temperature of the treated substrate to be controlled to desired temperature by measuring the incident heat amount on the treated substrate made the treatment in vacuum.

The present invention is a thin film making method on a semiconductor substrate, which has the characteristic that while maintaining at a desired temperature a semiconductor substrate on which thin film is to be formed by making charged particles incident thereon, thin film is formed on the semiconductor substrate.

Furthermore, the present invention is a thin film making method on a semiconductor substrate, which is characterized by measuring the incident heat amount on the semiconductor substrate which has thin film formed thereon by making charged particles incident thereon; introducing fluid between a substrate supporting member, on which said semiconductor substrate is placed and which is controlled to a desired temperature, and the semiconductor substrate; maintaining the temperature of the semiconductor substrate at desired temperature by controlling the pressure or flow rate of the fluid in correspondence with said heat amount measured; and thus forming thin film on the semiconductor substrate that is maintained at desired temperature.

In addition, the present invention is systems for working thin film, which are characterized by being equipped with a substrate supporting member to mount a treated substrate on which thin film is formed by making particles incident thereon, a temperature controlling means to control said substrate supporting member at desired temperature, a measuring means to measure the incident heat amount on said treated substrate, and a fluid controlling means to control the temperature of said treated substrate by introducing a thermal-conductive fluid between the treated substrate and the substrate supporting member and controlling the pressure or flow rate of the fluid in correspondence with the heat amount measured by said measuring means, and by working said thin film by making the film forming particles and the charged particles incident on said treated substrate.

Moreover, the present invention is systems for working thin film, which is characterised by being so constructed that in the systems for working thin film, said measuring means is equipped with a thermal conduction member which is placed so as to be in contact with fixed-temperature surface maintained at a fixed temperature, a 1st thermocouple which is placed in the vicinity of the fixed-temperature surface of said thermal conduction member, and a 2nd thermocouple which is placed in the vicinity of the heat receiving surface side, that is, the opposite side against the fixed-temperature surface of said thermal conduction member, and that the incident heat amount on said treated substrate is measured by measuring the incident heat amount on said thermal conduction member based on the temperature difference measured with the 1st and 2nd thermocouples.

In other words, the present invention has been designed as follows: to provide a heat amount sensor in the vicinity of said treated substrate on which thin film is worked by making particles incident thereon; to measure the incident heat amount on processed substrate; to accordingly control the pressure of fluid between the substrate supporting member, which is maintained at a certain temperature, and the substrate; thus, to enable the temperature of treated substrate to be controlled.

Furthermore, the present invention has been designed to be equipped with a heat amount sensor, with which the incident heat amount on a cylinder composing a thermal conduction member can be measured by using the thermal conduction member, whose specific thermal conductivity is known and which is substantially cylindrical in shape and whose longitudinal section along the rotation axis of said cylinder is sufficiently larger than its transverse section, then resembling thermal flow in the cylinder substantially unidimensional flow with one end of cylinder maintained at a certain temperature and the other end as a heat receiving surface and, moreover, by measuring the temperature of the two points along the axis in this cylinder, and with which the incident heat amount on the treated substrate can be measured. Assume that the circular radius of the bottom of the above-mentioned cylindrical thermal conduction member is r and that the length of the cylinder is $\ell$, it is preferable that $\ell$ represents 4 or more times of r, and in this case, the thermal flow can resemble substantially unidimensional flow.

In this specification, furthermore, the working of thin film primarily covers the formation of thin film, but not excluding the etching of thin film. Especially the bias-sputtering method, which is one example suited to apply the present invention, accompanies thin film forming and at the same time etching caused by ion bombardment on the deposited film on the substrate.

Since the present invention has enabled the measurement of the incident heat amount on a treated substrate on which thin film is worked by making particles incident thereon in the atmosphere of reduced pressure such as vacuum, an increase in the temperature of treated substrate caused by the particles made incident on treated substrate can be prevented. As a result, the temperature of treated substrate can be maintained and controlled to desired temperature, and high-quality thin film can be worked. In case that, for example, the connection film of VLSI is formed, since in the present invention, substrate temperature can be maintained at a desired level, connection film with low electric resistance can be obtained. Connection film with low electric resistance allows high electric current density such as 5 x $10^5$ A/$cm^2$, but no breaking of the connection, leading to long life to reach disconnection. Generally, electric resistance is low in case of film with high density and a low different phase concentration. In other words, the relationship between substrate temperature during formation of the film and the specific resistance of the film is experimentally investigated to obtain optimum substrate temperature at which we can get the lowest specific resistance, and thus, it is acceptable to maintain substrate temperature during formation of connection film at the temperature.

In case of thin film formation by sputtering, while heat radiated from a target and energy due to charged particles made incident from plasma on a semiconductor substrate vary dependently on electric power put in the target upon thin film formation by sputtering, but the amount of heat flowing into the semiconductor substrate has been designed to be able to be measured, enabling the control of semiconductor substrate temperature and the formation of high-quality thin film on semiconductor substrates.

When charged particles are, as in bias-sputtering method, actively introduced from plasma into a treated substrate to form film, the energy made incident on a substrate greatly varies dependently upon electric power applied to the substrate. Since it has been contrived that the amount of heat flowing into the substrate can be measured, substrate temperature can be controlled, and for example, thin film with low defect density or low resistivity can be formed.

In the present invention, a material with a high thermal conductivity such as copper is desirably used as that of said substrate supporting member. This is because the distribution of temperature in the surface of the substrate supporting member will become readily uniform by using a material with high thermal conductivity. Stainless steel, a common material for vacuum use, will be made acceptable by properly locating a channel of cooling water to maintain substrate supporting member at fixed temperature.

The material of the body of a heat amount sensor may be any one with an identified thermal conductivity, and is preferably stainless steel or oxygen free copper because of its degassing property in vacuum.

It is commonly acceptable to use a rare gas, which has little effect on treatment, as fluid to be introduced between a substrate and a substrate supporting member, and argon or helium gas is usually employed.

## BRIEF DESCRIPTION OF THE DRAWINGS

Fig. 1 is a schematic sectional view showing a portion (related to the control of substrate temperature) of a system for working thin film in one embodiment of the present invention;

Fig. 2 is a schematic sectional view showing a heat amount sensor in a system for working thin film in one embodiment of the present invention;

Fig. 3 is a schematic sectional view explaining a substrate supporting portion (having a heater and a heat amount sensor built in a substrate supporting member) of a system for working thin film in another embodiment of the present invention;

Fig. 4 is a graph showing the relation between overall heat transfer coefficient and the pressure of gas introduced between the substrate and the substrate supporting member;

Fig. 5 is a graph showing the time change of the substrate temperature with said gas pressure used as a parameter;

Fig. 6 is a graph showing the relation between said gas pressure and a desired substrate temperature with the incident heat amount as a parameter;

Fig. 7 is a schematic sectional view showing the bias-sputtering system for working thin film in still another embodiment of the present invention;

Fig. 8 is a graph showing the time change of the substrate temperature in each process of bias-sputtering working in still another embodiment of the present invention;

Fig. 9 is a graph showing the relation between specific resistance of Al-Cu-Si film formed by the bias-sputtering method and substrate temperature during film formation; and

Fig. 10 is a sectional view showing a multi layer wiring structure produced by bias-sputtering.

## DESCRIPTION OF THE PREFERRED EMBODIMENTS

The embodiments of the present invention will be hereunder described with reference to the drawings. Fig. 1 is a partial sectional view showing one embodiment of the substrate temperature controlling portion of a system for working thin film related with the present invention. To be specific, a substrate supporting member 10 is provided with a water channel 19 to make cooling water pass inside, allowing the passage of fixed-temperature cooling water whose temperature is controlled. The substrate supporting member 10 is made of copper with high thermal conductivity, with the water channel 19 provided so that the temperature of facing side against the substrate surface will become substantially the same as that of water.

The temperature of substrate supporting member 10 can be maintained at a fixed level by having a heater embedded to regulate the heater current as shown in Fig. 3, instead of providing a water channel 19 to ensure the flow of cooling water as described above.

A heat amount sensor 3 as shown in Fig. 2 is placed in the center of the substrate supporting member 10. The heat amount sensor 3 has heat insulated from the substrate supporting member 10 by a heat insulator 20.

It is preferable that the heat amount sensor 3 is placed as near the lower surface of the substrate 9 as possible. If the heat amount sensor 3 is located far away from the lower surface of substrate, heat may be taken away to substrate supporting member when measuring the amount of heat made incident on the substrate 9. The heat amount sensor 3 is preferably placed lower than the lower surface of substrate so as not to disturb the automatic attachment and detachment of the substrate 9 in a system for continuous treatment.

The heat amount sensor 3 is provided below the substrate 9 as described above. In order to further improve the accuracy of measurements, the amount of heat made incident on the position of substrate installation may be monitored with the heat amount sensor 3 under no presence of the substrate 9.

A gas 14 such as argon gas is introduced between the substrate 9 and the substrate supporting member 10. The gap between the substrate 9 and the substrate supporting member 10 is about 10 $\mu$m. The shorter this gap, the more preferable it is. Specifically, the overall heat transfer coefficient $\alpha$ as shown in Formula (2) below is dependent upon the gap between the substrate 9 and the substrate supporting member 10, and the value of $\alpha$ becomes higher as this gap is shortened. As indicated in Formula (2), since the overall heat transfer coefficient $\alpha$ becomes effective with a time constant up till substrate temperature becomes stationary temperature, the higher the overall heat transfer coefficient $\alpha$ is (that is, the shorter the gap between the substrate 9 and the substrate supporting member 10), the better the response of substrate temperature becomes and the faster the substrate 9 reaches constant temperature.

The incident heat amount on the substrate 9 and substrate temperature prior to film formation allow the gas pressure between the substrate 9 and the substrate supporting member 10 to be set so as to ensure a substrate temperature to be set during film formation. For example, as shown in Fig. 5, when the initial temperature of the substrate 9 is 200 °C and the amount of incident heat is $0.8 \times 10^4$ W/m$^2$, gas pressure will be set at 800 Pa for setting the substrate temperature during film formation at 100 °C. In order to maintain substrate temperature at a fixed level with remaining the temperature prior to film formation unchanged, gas pressure should, as illustrated in Fig. 6, be set in correspondence with the incident heat amount on substrate. If the incident heat amount on the substrate 9 has been measured with a dummy substrate in advance of film forming on the substrate 9, the measurement does not always to be performed whenever a substrate is treated.

No outlet of a fluid 14 such as argon is particularly provided. For practical use, there are gaps between the substrate 9 and the substrate supporting member 10, through which the fluid will leak. Generally, therefore, rare gases including Ar and He, which not adversely affect the treatment as described above, are used as said fluid 14. In addition, since the leakage of the above-mentioned gas varies from one case to another, in the present invention the gas pressure between the substrate 9 and the substrate supporting member 10 will be monitored, and the flow rate of the gas as the fluid will be controlled so that said gas pressure may become a predetermined pressure.

In Fig. 1, the numeral 13 denotes a pressure gauge, 21 a gas pressure controlling means, 22 a gas pressure calculating means, $T_1$ the temperature of cooling surface side of the heat amount sensor 3, $T_2$ the temperature of heat receiving surface side of the heat amount sensor 3, and T a predetermined substrate temperature.

Next, the measurements of the incident heat amount on the substrate 9 are described specifically. That is, Fig. 2 shows one example of the heat amount sensor 3 to measure the incident heat amount on the substrate 9. A sensor body 3a is made of a material with a previously known specific thermal conductivity (e.g., copper) and one end of the sensor allows the flow of temperature-controlled cooling water having a fixed temperature. One thermocouple 1 is embedded in the vicinity of the cooling surface 7 of this sensor, and moreover, the second thermocouple 2 is embedded with a predetermined distance ($\ell$) off the first

thermocouple by the side of the heat receiving surface 8 of sensor. In a stationary state, the relationship between the amount of heat q flowing into the sensor and temperatures $T_1$ and $T_2$ indicated by both thermocouples is represented by the following formula:

$q = \lambda (T_2 - T_1)/\ell$ (1)

wherein,

q : heat amount per unit time/unit area (W/m$^2$

$\lambda$ : specific thermal conductivity (W/m•°C)

$T_1$: temperature of cooling surface side (temperature indicated by the first thermocouple) (°C)

$T_2$: temperature of heat receiving surface side (temperature indicated by the second thermocouple) (°C)

$\ell$ : distance of the temperature measuring points between both thermocouples (m)

Since $\lambda$ and $\ell$ are known, the measurements of $T_1$ and $T_2$ will permit incident heat amount q to be obtained from the above-mentioned formula (1) in a gas pressure calculating means 22 composed of microcomputers, etc.

In Fig. 2, the numeral 4 denotes a cooling water channel, 5 a joint, 6 a filler, and 13′ gas pressure indicated by a pressure gauge 13, and the symbol P gas pressure, with T, C, $\alpha$, $T_0$, and Ti being presented in the description of Formula (2).

Then, heat transfer between the substrate 9 and the substrate supporting member 10 will be described with reference to Figs. 1 and 3.

A fluid 14, for example, argon is introduced between the substrate 9 and the substrate supporting member 10. The pressure between the substrate 9 and the substrate supporting member 10 is measured with the pressure gauge 13 fitted to the substrate supporting member 10. In Fig. 3, the substrate supporting member has a heater 16 embedded. With temperature of the substrate supporting member 10 measured with a thermocouple 15, the temperature $T_0$ of substrate supporting member is maintained at a fixed level by feedback of said measured values to a heater power source 1 from a temperature monitor 18. In Fig. 1, the temperature $T_0$ is maintained to be fixed with cooling water passing through the water channel 19. The relationship between incident heat amount q on the substrate 9 and substrate temperature T is represented by the following formula:

$$T = \{(Ti - T_0) - \frac{q}{\alpha}\}e^{-\frac{\alpha}{c}t} + \frac{q + \alpha T_0}{\alpha} \quad \cdots \quad (2)$$

wherein,

q : incident heat amount on substrate per unit time and unit area (W/m$^2$)

c : heat capacity per unit area of substrate (W•sec/m$^2$•°C)

T : temperature of substrate at time t (°C)

$T_0$: temperature of substrate supporting member 10 (°C)

$\alpha$ : overall heat transfer coefficient (W/m$^2$•°C)

Ti: initial temperature of substrate (temperature at t = 0) (°C)

t : time (sec)

Incident heat amount q on substrate is equal to incident heat amount q on heat amount sensor, and can be measured with the above-mentioned heat amount sensor 3 as described above.

$T_0$ can be measured with the thermocouple 15 fitted to the substrate supporting member 10.

In addition, since the heat emissivity of substrate prior to film formation is fixed, if calibration has been performed beforehand, substrate temperature Ti immediately before film forming can be measured with an infrared thermometer or the like. Heat capacity C can be learned from the table of material physical properties if the substrate material is identified.

With regard to overall heat transfer coefficient $\alpha$, the determination of the kind of gas to be introduced, the gap and the gas pressure, respectively, between the substrate 9 and the substrate supporting member 10 enables said coefficient value to be experimentally obtained using Formula (2). For example, with the substrate supporting member 10 water-cooled and maintained at a fixed level of 20°C, the substrate 9 with an identified initial temperature is mounted on said substrate supporting member 10, and the temperature change of the substrate 9 is then measured, thus allowing calculation of overall heat transfer coefficient $\alpha$.

Specifically, a dummy substrate with known heat capacity per unit volume, dimensions and shape is used to obtain an o value from Formula (2). If, Si having, for example, a specific heat of 0.761 J/g•K and a density of 2.329 g/cm$^3$ is formed into a wafer with a diameter of 150 mm and a thickness of 0.49 mm to be used as a substrate, the heat capacity C per unit area of the substrate is shown by the following formula:

$C = 0.761 \times 2.329 \times 0.49 \times 10^4 \fallingdotseq 870$
(W•sec/m²•°C). A thermocouple is fitted to this substrate with silver paste, and overall heat transfer coefficient $\alpha$ is obtained based on the temperature change thereof. In other words, assume q = 0 in Formula (2),

$$\alpha = -\frac{c}{t}\ell n\left(\frac{T - T_0}{Ti - T_0}\right)$$

so measurements of the initial temperature Ti of substrate and substrate temperature T after t sec will allow calculation of overall heat transfer coefficient by the foregoing formula.

The gas pressure calculating means 22, composed of microcomputers, etc. as described above, calculates overall heat transfer coefficient $\alpha$, which allows substrate temperature T to become a desired temperature, based on the relationship in the above-mentioned Formula (2), from the calculated incident heat amount q, heat capacity C put in the calculating means 22, the initial temperature Ti of substrate, and the temperature $T_0$ of the substrate supporting member 10 measured by the thermocouple 15, and calculates gas pressure P from the relationship between overall heat transfer coefficient $\alpha$ put in the calculating means 22 and gas pressure P. And the gas pressure controlling means 21 controls the gas pressure detected out of the pressure gauge 13 so as to become gas pressure P which has been calculated by the gas pressure calculating means 22, thus causing the substrate 9 to be maintained at the desired temperature.

Fig. 4 shows the relationship between overall heat transfer coefficient $\alpha$ and gas pressure P assuming that the gas 14 is argon and that the gap between the substrate 9 and the substrate supporting member is 10 µm.

Fig. 5 shows the time changes of substrate temperature T depending upon the gas pressure P when the temperature $T_0$ of the substrate supporting member is set as 20°C, the initial temperature Ti of substrate as 200°C, incident heat amount q as $0.8 \times 10^4$ W/m², and heat capacity C per unit area of the substrate 9 as $8.70 \times 10^2$ W•sec/m²•°C. If gas pressure P is 800 Pa, substrate temperature T becomes a stationary temperature of 100°C after about 30 second. When gas pressure P is set as 341 Pa, substrate temperature T can be controlled to be fixed with initial substrate temperature Ti maintained during film formation.

Fig. 6 shows gas pressure P to maintain the substrate temperature at a fixed levels during film formation against incident heat amount q, when the temperature $T_0$ of the substrate supporting member 10 is set as 20°C, and the heat capacity C per unit area of the substrate 9 as $8.70 \times 10^2$ W•sec/m²•°C. When, for example, incident heat amount q is $1.0 \times 10^4$ W/m², it is satisfactory to set gas pressure P as 320 Pa to maintain the substrate temperature T during film formation at desired level of 300°C.

In any case, the temperature T of substrate during working of thin film can be maintained at desired level by calculating the overall heat transfer coefficient $\alpha$ from the relationship in the above-mentioned Formula (2) in correspondence with incident heat amount q as calculated from the relationship in said Formula (1) by the gas pressure calculating means 22, calculating gas pressure P based on overall heat transfer coefficient $\alpha$ as calculated and then allowing the gas pressure controlling means 21 to control gas pressure so as to become gas pressure P as calculated. If the characteristics as shown in Fig. 6 have been obtained in advance, the gas pressure calculating means 22 can calculate the gas pressure P directly from the relationship between the incident heat amount q as calculated from the relationship in the above-mentioned Formula (1) and the desired temperature T of substrate during working of thin film. And the gas pressure controlling means 21 can maintain the substrate temperature T at desired level during working of film by controlling the gas pressure so as to become the gas pressure P as calculated.

As described above, the temperature of substrate, on which film forming particles or charged particles are made incident for working thin film, can be accurately controlled.

Moreover, there is, as shown in Figs. 1 and 3, a substrate chucking mechanism 11 in the neighborhood of substrate 9, which minimizes the leakage of the gas 14 for heat transfer through the gap between the substrate 9 and the substrate supporting member 10, and which opens and closes with the output of up and down motion of a plunger 12, thus pressing the substrate 9 to the substrate supporting member 10 for fixing the substrate on the substrate supporting member.

Another one is a substrate handling mechanism, but it is not described in detail because it is not directly related with the present invention.

When the present invention is applied to a system for continuous treatment, an attaching/detaching and transfer mechanism as commonly used is obviously required.

In order to measure the incident heat amount on the substrate 9, it is not always necessary to place the heat amount sensor 3 below the substrate as in this example. If the incident heat amount on substrate has been obtained in advance by the heat amount sensor 3 placed below the substrate and if at such a time, a heat amount sensor is provided in the vicinity and on the periphery of the substrate, thus ensuring the correlation of heat amount as calculated from both of the above, then the incident heat amount on substrate can be subsequently obtained by the heat amount sensor placed in the vicinity and on the periphery of the substrate. The above-mentioned correlation, however, varies dependent upon the conditions of film formation, so it is necessary to take the correlation for each film making condition. As a consequence, preferable is a method like this embodiment, by which the incident heat amount on substrate can be measured even when the conditions of film formation are different.

The specific examples of thin film working will here under be described.

Example 1

Fig. 7 shows an example in which the present invention has been applied to a bias-sputtering system. A sputtering electrode 25 is placed facing the substrate supporting member 10. Voltage is applied to the substrate supporting member 10 by an electric power supply 23 to irradiate the substrate 9 with the ions from plasma 27 which are produced by glow discharge above the substrate. Since positive ions are normally used, the applied voltage is negative to earth potential. The incident heat amount on the substrate changes due to input electric power to the sputtering electrode 25 and applied voltage on the substrate supporting member 10. In order to control the temperature of the substrate during film formation, therefore, it is necessary to obtain in advance the incident heat amount on the substrate 9 using a dummy substrate during or prior to film formation. The present invention acts to enable the control of gas pressure P so as to control the substrate temperature T during film formation, by learning incident heat amount q and substrate temperature Ti prior to film formation and temperature $T_0$ of the substrate supporting member 10 as described above.

In this example, Si, GaAs, or GaAlAs was used as the substrate 9, and good results were obtained from any of them.

In Fig. 7, the numeral 3 denotes a heat amount sensor, 11 a substrate chucking mechanism, 12 a plunger, 14 a fluid, 20 a heat insulator, 21 a gas pressure controlling means, 22 a gas pressure calculating means, and 24 a power source, and the symbol $T_1$ denotes the temperature of cooling surface side of the heat amount sensor 3, and $T_2$ the temperature of heat receiving surface side of the heat amount sensor 3.

Maintenance of the substrate at a high and fixed temperature during film formation is satisfied by the following processes: a heater 16 is, as shown in Fig. 3, placed inside the substrate supporting member; and ON-OFF control of the heater 16 is performed with a heater power source 17 while monitoring the temperature of the substrate supporting member 10 on a temperature monitor 18 so that the temperature of the substrate supporting member 10 is maintained at a high and fixed level. This case as well, learning of incident heat amount q and substrate temperature Ti prior to film formation and temperature $T_0$ of the substrate supporting member leads to the control of gas pressure P and substrate temperature T during film formation.

Example 2

Next, an example in which the present invention is applied to a sputtering system will be described using Fig. 7. Namely, the interconnection film of LSI is formed. In the sputtering system the following processes are taken in usual. The substrate 9 first is detached moisture, which has been attached to the surface of substrate in the air, by baking it in vacuum before forming film. Usually, baking treatment is completed by heating for one minute at 300 to 500 °C in the vacuum at the level of $10^{-6}$ to $10^{-7}$ Torr. Baking temperature is set higher than the highest temperature in the next process. After this baking treatment, sputtering-etching treatment is carried out to remove naturally oxidized film formed on the surface of substrate. This is for the purpose of getting the good electrical connection between under connection layer formed on the substrate 9 and upper connection layer. Since the substrate temperature after these treatments is unknown, it is first measured with a radiation thermometer before film making treatment. When substrate temperature is higher than a temperature at which film forming treatment is performed, the substrate is left to be cooled, or a gas 14 is introduced into the gap between the substrate 9 and the substrate supporting member 10 after carrying it to the substrate supporting member 10, and the substrate is then cooled down to a predetermined temperature Ti. This is followed by film forming treatment. During film formation, gas pressure P between the substrate 9 and the substrate supporting member 10 is set in correspondence with incident heat amount q as measured in advance, thus maintaining substrate temperature T at a fixed level. Or during film formation, the above-mentioned gas pressure P is controlled so that substrate temperature will become a given temperature profile. The temperature profile is set under the condition that a good quality film is obtained dependent upon a film material for film formation.

In the present example, Si, GaAs or GaAlAs was used as the substrate 9, and good results were obtained from any of them.

When the substrate temperature is lower than a temperature at which film making treatment is performed, the substrate is heated up to a predetermined temperature using a heater block as set forth in pages 41 to 48 of the Solid State Technology, Japanese edition, March (1981), and the substrate temperature prior to film formation is made higher than the temperature during film formation. Subsequently, the same procedure as described above should be followed. Elevation of the substrate temperature can also be carried out with the substrate supporting member which has a heater for film making and is maintained at a high temperature. In this case it is not always necessary to separately provide a heater which re-heats the substrate after sputtering-etching treatment. Fig. 8 shows one example of substrate temperature profile.

In the drawing, such processes as substrate baking treatment, sputtering-etching treatment, substrate temperature controlling treatment before film forming, film forming treatment, and transfer were presented together.

In the above-mentioned embodiment, furthermore, while the sputtering system and the bias-sputtering system were described, it is apparent that the present invention can be applied to vacuum evaporation system, etching system, CVD system, electron beam working system, and ion beam working system or the like.

Example 3

In addition, the above-mentioned bias-sputtering system enables film to be formed to connect an upper interconnection layer 31 of a semiconductor device such as VLSI or the like having multi-layer interconnection and 31 as shown in Fig. 10 with a lower electrode or lower interconnection layer 30 via a through hole 32. Since especially as shown in Fig. 7, bias-sputtering has been designed to be performed so that ions in plasma will be weakly drawn into a semiconductor substrate (element) by the power source 23, superior upper layer interconnection film can be formed on interlayer insulating film 33 by causing migration for the upper interconnection layer wiring adhering to the inlet of the above-mentioned through hole 32 and then forming thin film with a uniform thickness on the side wall and bottom inside the through hole. Additionally, the numeral 34 denotes a semiconductor substrate of Si or the like, and 35 and 36 insulating films.

Thus in accordance with this example, substrate temperature during film formation can be accurately controlled. In case that, for example, TiN thin film is formed on a semiconductor substrate, defects included in the film can be reduced by maintaining substrate temperature at 650 °C and, moreover, allowing bias-sputtering or the like to irradiate ions with proper energy during formation of the film. When there is no irradiation of ions in plasma, on the other hand, unless substrate temperature is further raised to some 850 °C, the above-mentioned defects cannot be reduced to the same level of defect density. As clearly seen from this phenomenon, if substrate temperature can be controlled, it will become possible to form film with the low defect density that has not been achieved previously. In case of TiN thin film, for example, film with still lower defect density can be obtained by controlling ion irradiating energy and substrate temperature independently.

Fig. 9 shows the data developed when film was formed while controlling substrate temperature with Al-3 wt% Cu-1 wt% Si used as wiring material and with ion irradiation at incident ion amount of 4.1 $mA/cm^2$ and ion energy of 100 eV. Maintenance of substrate temperature at 200 to 300 °C enables the specific resistance of film to be reduced to 3.5 μΩcm or lower. An optimum substrate temperature or irradiation ionic energy and its amount naturally varies dependent upon a film material. Since the present invention enables substrate temperature to be controlled with consideration of ion irradiation energy and incident ion amount, an optimum temperature to meet the film material can be selected, thus making it possible to form high-quality film.

Incidentally, in the present invention, conventional knowledges and known teachings may be adopted in connection with matters not specifically described in the instant specification.

In accordance with the present invention, as described above, in the method of, and a system for, working thin film to work thin film with particles made incident on treated substrate in a vacuum atmosphere of 1 Torr or less or a low pressure atmosphere, the effect is exhibited to enable accurate control of the temperature of treated substrate and achievement of the thin film which is free from defects or has superior characteristics and high quality. Particularly, in accordance with the present invention, the temperature of treated substrate can be controlled to desired level, and high quality thin film resulting from thin film working can thus be obtained, by measuring the incident heat amount on the treated substrate and controlling the pressure or flow rate of a fluid introduced between the treated substrate and the substrate supporting member in correspondence with the heat amount as measured.

## Claims

1. A thin film working method on a semiconductor substrate, characterized in that said thin film is worked on said semiconductor substrate (9) while maintaining said semiconductor substrate (9) at desired temperature and making particles incident thereon.

2. A thin film working method on a semiconductor substrate, characterized in that said method comprises the steps of measuring the incident heat amount on said semiconductor substrate (9) on which said thin film is worked by making particles incident thereon; introducing a fluid (14) between a substrate supporting member (10), on which said semiconductor substrate (9) is mounted and which is controlled at a desired temperature, and said semiconductor substrate (9); controlling the pressure of said fluid (14) in correspondence with said heat amount as measured to maintain said semiconductor substrate (9) at a desired temperature; and working thin film on said semiconductor substrate (9) which is maintained at a desired temperature.

3. A thin film forming method on a semiconductor substrate, characterized in that said thin film is formed by bias-sputtering on said semiconductor substrate (9) by making at least charged particles incident on said semiconductor substrate (9) which is maintained at a desired temperature.

4. A thin film forming method on a semiconductor substrate, characterized in that said method comprises the steps of measuring an incident heat amount on said semiconductor substrate (9), on which said thin film is formed by making at least particles incident thereon; introducing a fluid (14) between a substrate supporting member (10), on which said semiconductor substrate (9) is mounted and which is controlled at a desired temperature, and said semiconductor substrate (9); controlling the pressure of said fluid (14) in correspondence with said heat amount as measured to maintain said semiconductor substrate (9) at a desired temperature; and forming thin film on said semiconductor substrate (9), which is maintained at a desired temperature, by sputtering.

5. A system for working a thin film, characterized in that said system is equipped with a substrate supporting member (10) on which a treated substrate (9) is mounted on which thin film is worked by making particles incident; a temperature controlling means to control said substrate supporting member (10) at a desired temperature; a measuring means (3) to measure the incident heat amount on said treated substrate (9); and a fluid controlling means (21) to introduce a thermal-conductive fluid (14) between said treated substrate (9) and said substrate supporting member (10), control the pressure of said fluid in correspondence with the heat amount measured by said measuring means (3) to control the temperature of said treated substrate (9), and that on said treated substrate (9), film forming particles or charged particles are made to be incident to work said thin film.

6. A system for working a thin film as set forth in claim 5, characterized in that said measuring means (3) is equipped with a thermal conduction member (3a) which is placed in contact with a fixed-temperature surface which is maintained at a fixed temperature, a first thermocouple (1) placed in the vicinity of the fixed-temperature surface of said thermal conduction member (3a), and a second thermocouple (2) placed on heat receiving surface side (8) which is opposite to the fixed-temperature surface of said thermal conduction member, and that the incident heat amount on said treated substrate (9) is measured by measuring the incident heat amount on said thermal conduction member (3a) based on the temperature difference measured with said first and second thermocouples (1, 2).

7. A system for forming a thin film on a semiconductor substrate, characterized in that said system is equipped with a substrate supporting member (10) on which is mounted a semiconductor substrate (9) on which thin film is formed by making at least charged particles incident thereon; a temperature controlling means to control said substrate supporting member (10) to a desired temperature; a measuring means (3) to measure the incident heat amount on said semiconductor substrate; and a fluid controlling means (21) to introduce a thermal-conductive fluid (14) between said semiconductor substrate (9) and said substrate supporting member (10), and to control the pressure of said fluid (14) in correspondence with the heat amount measured by said measuring means (3) to control the temperature of said semiconductor substrate (9), and that a thin film is formed by making film forming particles incident on said semiconductor substrate (9), by sputtering.

8. A system for forming a thin film on a semiconductor substrate as set forth in claim 7, characterized in that said measuring means (3) is equipped with a thermal conduction member (3a) placed in contact with fixed-temperature surface which is maintained at a fixed temperature, a first thermocouple placed in the vicinity of the fixed-temperature surface of said thermal conduction member (3a), and a second thermocouple placed on heat receiving surface side which is opposite to the fixed temperature surface of said thermal conduction member (3a), and that the incident heat amount on said substrate (9) is measured by measuring the incident heat amount on said thermal conduction member (3a) based on the temperature difference measured with said first and second thermocouples (1, 2).

FIG. 1

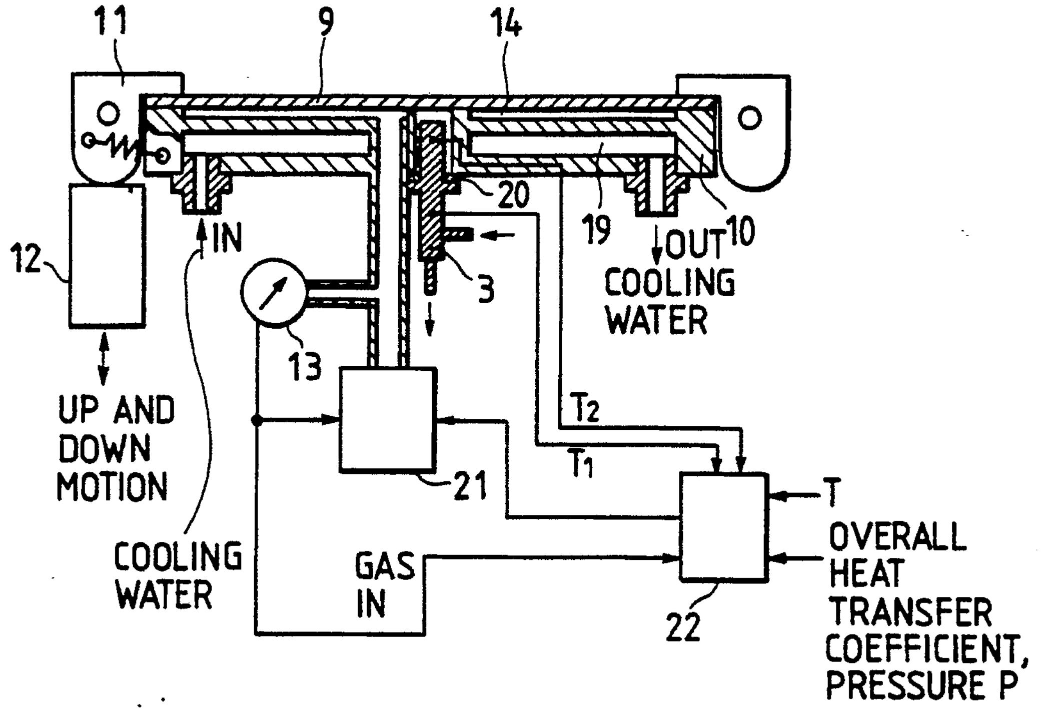
11
9
14
20
19
10
IN
OUT
COOLING WATER
12
3
13
UP AND DOWN MOTION
T2
T1
21
T
OVERALL HEAT TRANSFER COEFFICIENT, PRESSURE P
COOLING WATER
GAS IN
22

FIG. 2

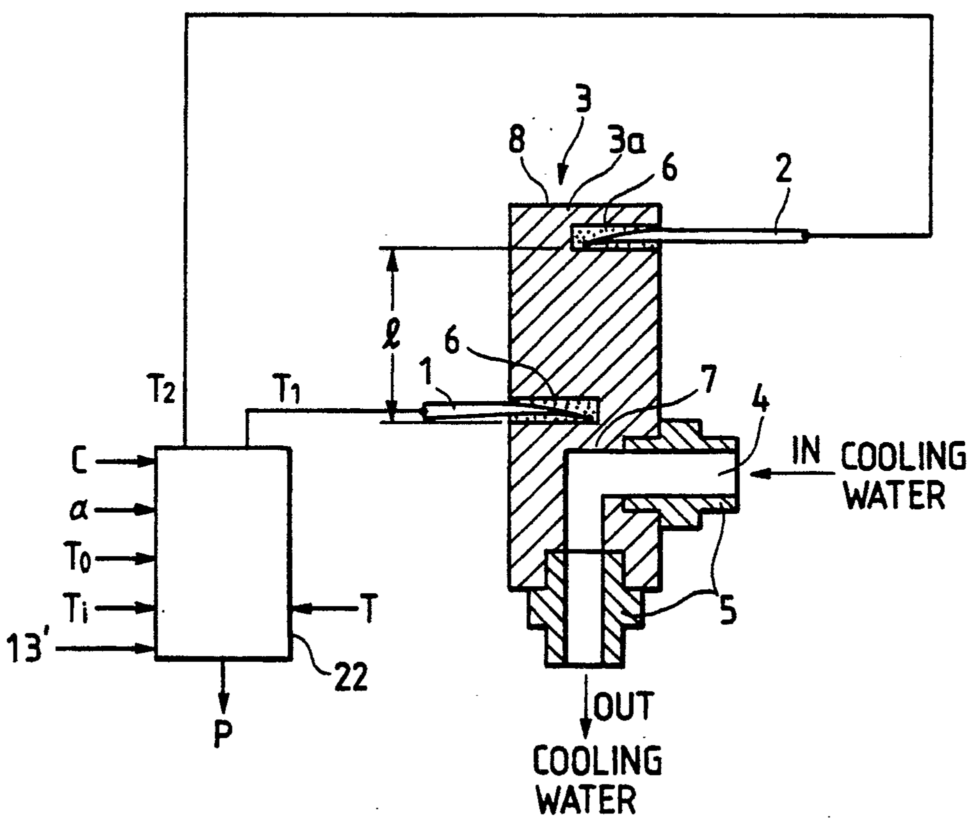
3
8
3a
6
2
ℓ
6
1
7
4
T2
T1
IN COOLING WATER
C
α
T0
Ti
T
13'
22
5
P
OUT
COOLING WATER

FIG. 3

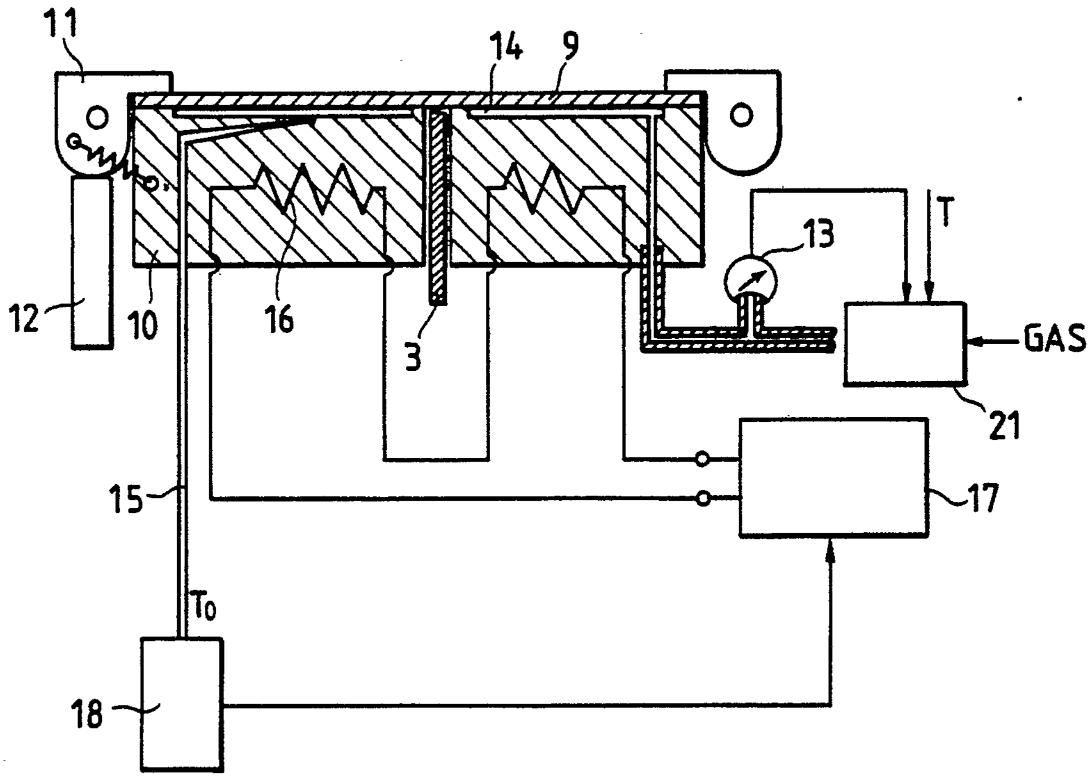
11
14
9
13
T
GAS
12
10
16
3
21
17
15
T0
18

FIG. 4

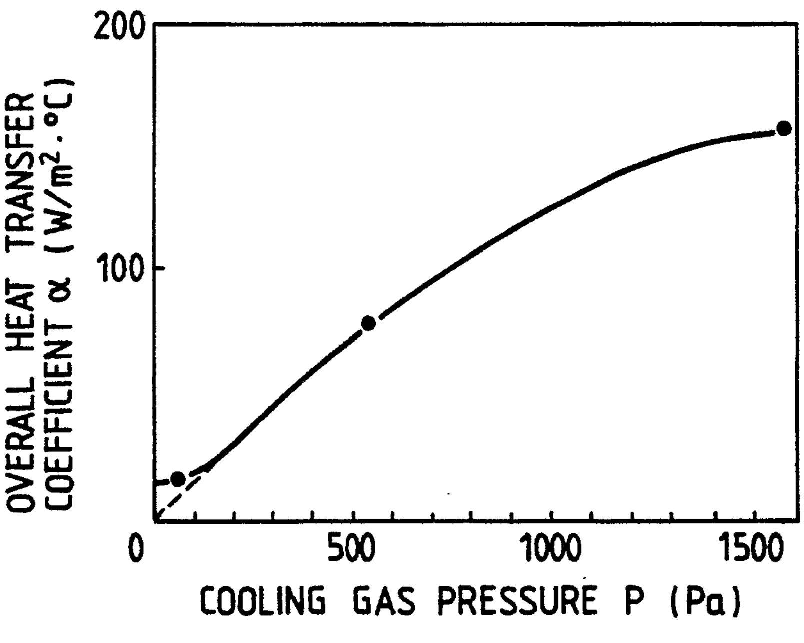
200
100
0
500
1000
1500
OVERALL HEAT TRANSFER
COEFFICIENT α (W/m2.°C)
COOLING GAS PRESSURE P (Pa)

FIG. 5

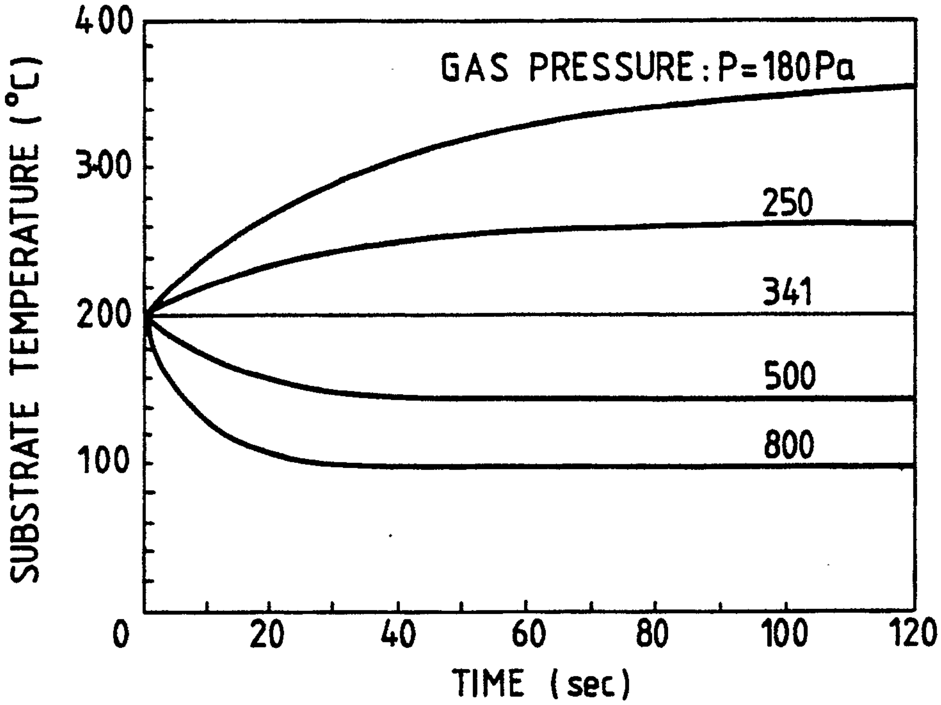
400
300
200
100
0
SUBSTRATE TEMPERATURE (°C)
GAS PRESSURE: P=180Pa
250
341
500
800
20
40
60
80
100
120
TIME (sec)

FIG. 6

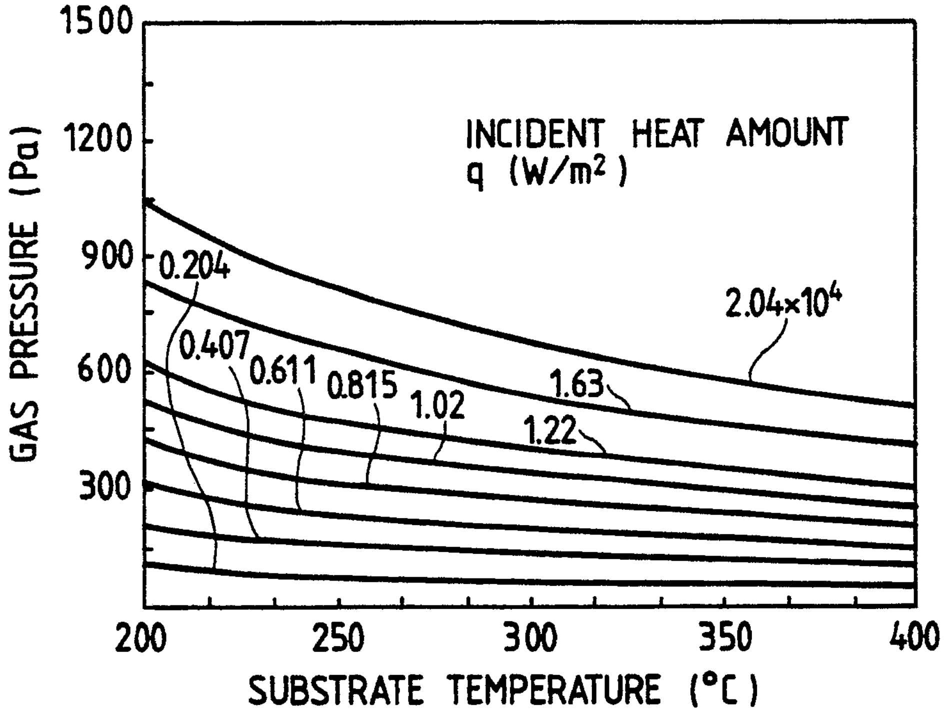
1500
1200
900
600
300
GAS PRESSURE (Pa)
INCIDENT HEAT AMOUNT
q (W/m²)
0.204
0.407
0.611
0.815
1.02
1.22
1.63
2.04×10⁴
200
250
300
350
400
SUBSTRATE TEMPERATURE (°C)

FIG. 7

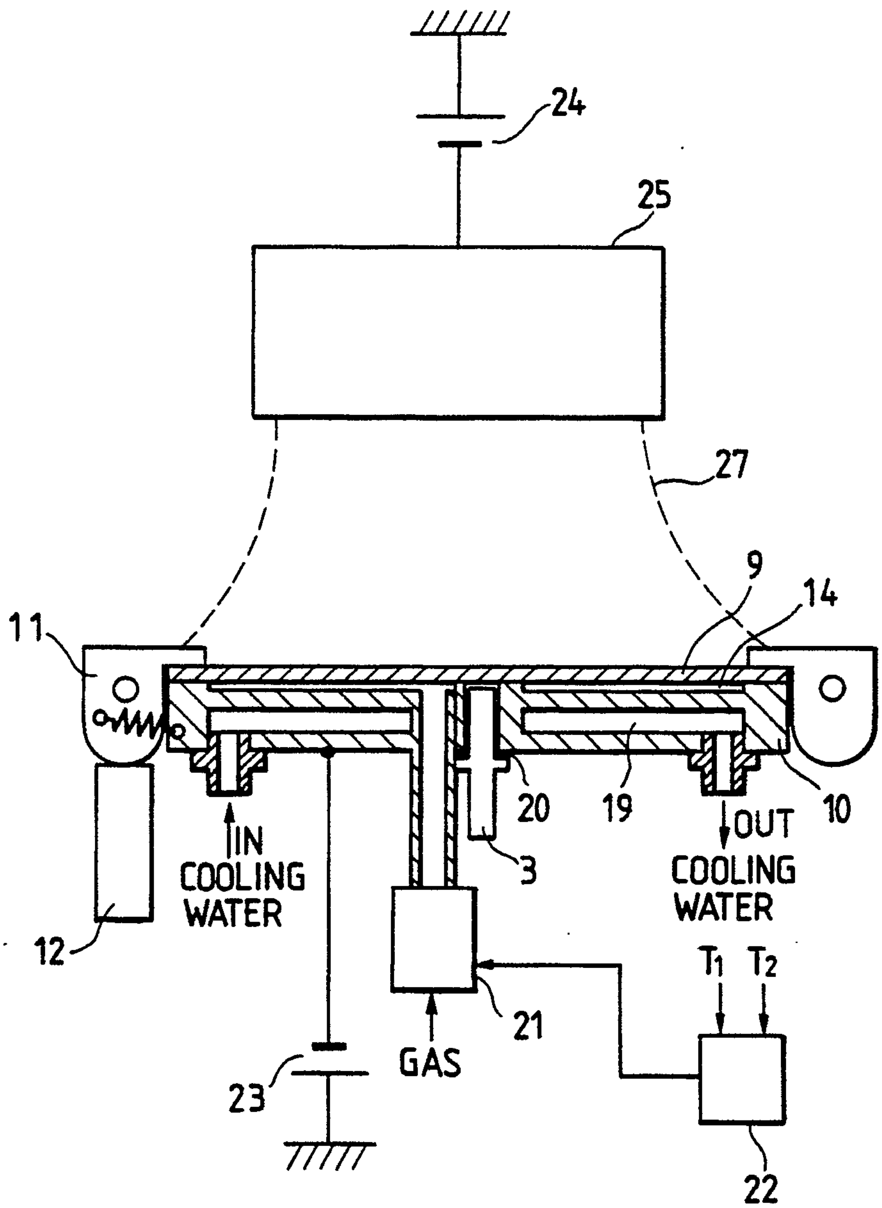
24
25
27
9
14
11
12
IN
COOLING
WATER
3
20
19
OUT
COOLING
WATER
10
21
GAS
23
T1
T2
22

FIG. 8

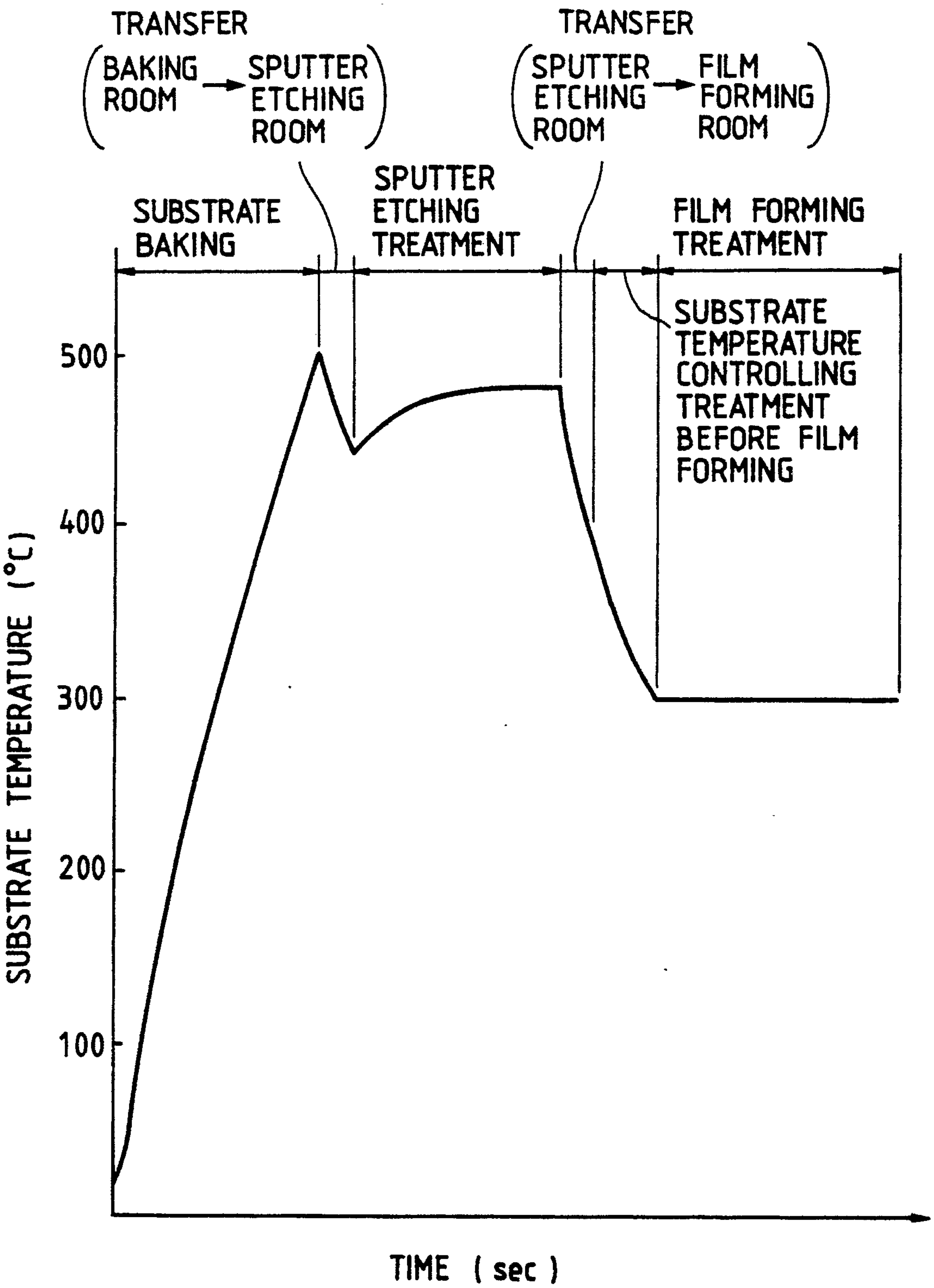
TRANSFER
(BAKING ROOM → SPUTTER ETCHING ROOM)
TRANSFER
(SPUTTER ETCHING ROOM → FILM FORMING ROOM)
SUBSTRATE BAKING
SPUTTER ETCHING TREATMENT
FILM FORMING TREATMENT
SUBSTRATE TEMPERATURE CONTROLLING TREATMENT BEFORE FILM FORMING
500
400
300
200
100
SUBSTRATE TEMPERATURE (°C)
TIME ( sec )

FIG. 9

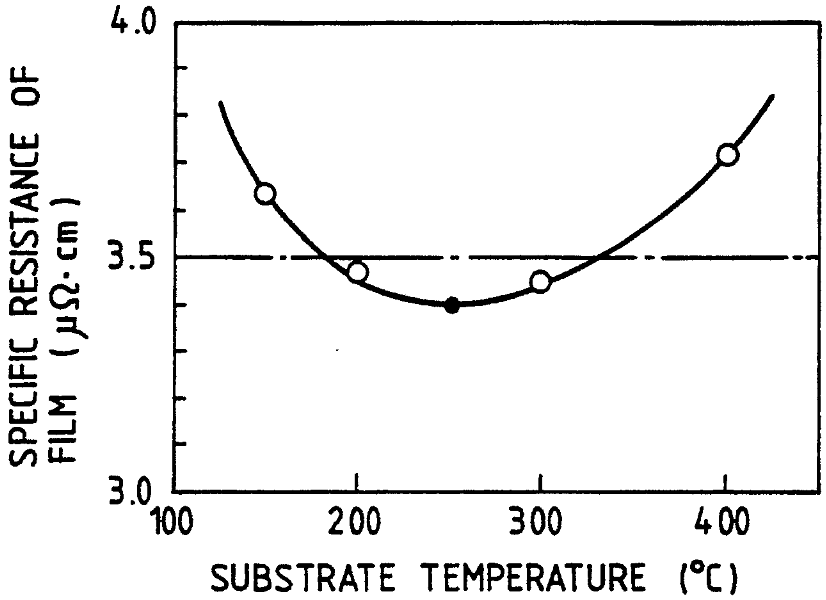
SPECIFIC RESISTANCE OF FILM ( μΩ·cm )
4.0
3.5
3.0
100
200
300
400
SUBSTRATE TEMPERATURE (°C)

FIG. 10

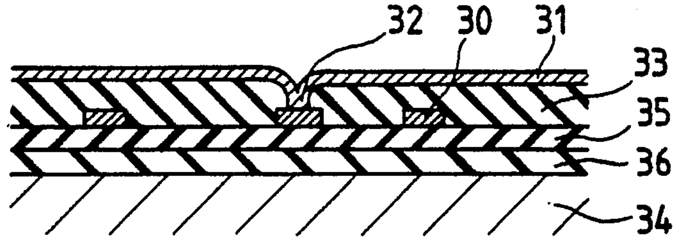
32
30
31
33
35
36
34